# EUROPÄISCHE PATENTSCHRIFT

(11) **EP 3 521 838 B1**
(45) Veröffentlichungstag und Bekanntmachung des Hinweises auf die Patenterteilung: **25.11.2020**
(21) Anmeldenummer: 18154618.5
(22) Anmeldetag: 01.02.2018
(51) Int. Cl.: G01R 27/02, G01R 31/36

(54) **VORRICHTUNG ZUM MESSEN DER IMPEDANZ EINES ELEKTROCHEMISCHEN ENERGIESPEICHERS**
DEVICE FOR MEASURING THE IMPEDANCE OF AN ELECTROCHEMICAL ENERGY STORAGE DEVICE
DISPOSITIF DE MESURE D'IMPÉDANCE D'UN ACCUMULATEUR D'ÉNERGIE ÉLECTROCHIMIQUE

(43) Veröffentlichungstag der Anmeldung: 07.08.2019
(73) Patentinhaber: Technische Universität Graz, 8010 Graz (AT); Kober Engineering GmbH, 8262 Ilz (AT)
(72) Erfinder: EICHBERGER, Bernd, 8010 Graz (AT); KOBER, Werner, 8262 Ilz (AT)
(74) Vertreter: Weiser & Voith Patentanwälte Partnerschaft

(56) Entgegenhaltungen:
- EP-A1- 2 494 372
- EP-A1- 3 217 458
- EP-A2- 2 733 564
- WO-A1-2012/085800
- CN-A- 106 199 200
- DE-A1-102012 214 804
- DE-A1-102015 203 878
- JP-A- 2012 093 367
- JP-A- 2017 150 838
- US-A1- 2015 024 295

## Beschreibung

Die vorliegende Erfindung betrifft eine Vorrichtung zum Messen der Impedanz eines elektrochemischen Energiespeichers, welcher eine angeschlossene Last mit einem Laststrom über eine Leitung speist, wobei die Vorrichtung die genannte Leitung, eine Stromspeiseeinrichtung zum Einspeisen eines den Laststrom überlagernden Wechselstroms, ein dem elektrochemischen Energiespeicher parallelschaltbares Spannungsmessgerät zur Spannungsmessung, ein in die Leitung eingeschaltetes Strommessgerät zur Strommessung und eine Einrichtung zur Bestimmung der Impedanz aus Spannungs- und Strommessung umfasst.

Als elektrochemische Energiespeicher werden z.B. galvanische Elemente (Batterien, Akkumulatoren) oder Redox-Flussspeicher und insbesondere auch Brennstoffzellen verstanden.

Impedanzmessungen an einem elektrochemischen Energiespeicher werden insbesondere durchgeführt, um Rückschlüsse auf seinen Zustand zu ziehen, z.B. auf den Ladezustand, die Alterung, die Speicherkapazität, den Betriebszustand od.dgl. Vielfach sind reine Labor-Messwerte nicht ausreichend realitätsnah und/oder Informationen über den Zustand des elektrochemischen Energiespeichers während des normalen Lastbetriebs gewünscht, sodass währenddessen die Impedanzmessung erforderlich ist.

Zur Impedanzmessung wird im Allgemeinen die Stromspeiseeinrichtung dem elektrochemischen Energiespeicher parallelgeschaltet und so der Wechselstrom eingespeist. Bei höheren Ausgangsspannungen, welche beispielsweise für Fahrzeugantriebe von Automobilen notwendig sind, wird das Einkoppeln des Wechselstroms schaltungstechnisch zunehmend anspruchsvoll. Ferner kann die an dem elektrochemischen Energiespeicher angeschlossene Last das Ergebnis der Impedanzmessung signifikant verfälschen, insbesondere wenn die Last ein einen Fahrantrieb speisender elektronischer Umrichter ist, welcher zwischen seinen Versorgungsanschlüssen Elektrolytkondensatoren geringer Impedanz hat. Für eine unverfälschte Impedanzmessung wäre deshalb ein Abtrennen der Last vom elektrochemischen Energiespeicher wünschenswert, was jedoch für eine Messung im normalen Lastbetrieb nicht infrage kommt.

Aus der EP 3 168 629 A1 ist bekannt, zwischen den elektrochemischen Energiespeicher und die Last eine Drosselspule zu setzen. Um den gesamten Laststrom führen und eine gute Entkopplung des elektrochemischen Energiespeichers von der Last bewirken zu können, muss eine solche Drosselspule allerdings entsprechend groß bemessen sein. Zur Impedanzmessung einer Brennstoffzelle, an welche eine Pufferbatterie und die Last über Spannungsumrichter angeschlossen sind, mithilfe von Strom- und Spannungsmessgeräten beschreibt die EP 3 217 458 A1 die Verwendung einer Wechselstromquelle, welche optional in Serie mit der Brennstoffzelle schaltbar ist. Auch in dieser Anordnung wirkt die Last auf die Messung zurück und verfälscht deren Ergebnis. Weitere Beispiele für Impedanzmessvorrichtungen zum Messen der Impedanz eines elektrochemischen Energiespeichers sind in den Druckschriften DE 10 2012 214804 A1 und CN 106 199 200 A offenbart.

Die Erfindung setzt sich zum Ziel, eine Vorrichtung zum präzisen Messen der Impedanz eines elektrochemischen Energiespeichers zu schaffen, welche im normalen Betrieb mit angeschlossener Last platzsparend und auch bei höherer elektrischer Spannung des elektrochemischen Energiespeichers ohne wesentlich höheren Schaltungsaufwand einsetzbar ist.

Dieses Ziel wird erfindungsgemäß mit einer Vorrichtung der einleitend genannten Art erreicht, welche sich dadurch auszeichnet, dass die Stromspeiseeinrichtung ein in die Leitung eingeschalteter Zweipol mit gesteuerter Stromquelle ist.

Ein solcher, zwischen den elektrochemischen Energiespeicher und die Last in Serie geschalteter Zweipol entkoppelt aufgrund des hohen differenziellen Widerstands der gesteuerten Stromquelle die Impedanz des elektrochemischen Energiespeichers von jener der Last, d.h. die Einflüsse der Impedanz der Last und überlagerter Störspannungen werden wirkungsvoll unterdrückt. Aus Spannungs- und Strommessung kann so die Impedanz des elektrochemischen Energiespeichers mit hoher Genauigkeit und ohne voluminöse Drosselspule bestimmt werden. Aufgrund der seriellen Schaltung des Zweipols in die Leitung ist der Schaltungsaufwand weitgehend unabhängig von der Spannung des elektrochemischen Energiespeichers.

Zur Steuerung der Stromquelle sind ein Spannungsregler, welcher eine Messeinheit zum Messen des Spannungsabfalls an der Stromquelle und einen Verstärker zum Bilden eines Steuersignals aus einer Differenz des gemessenen Spannungsabfalls und eines vorgegebenen Sollwerts umfasst, und eine Wechselspannungsquelle zum Einkoppeln einer Wechselspannung in das genannte Steuersignal vorgesehen. Für Gleichstrom- und Wechselstromanteile mit niedrigen Frequenzen, d.h. je nach Aufbau des Zweipols einigen 10 Hz bis wenigen 100 Hz, typisch bis etwa 100 Hz, kann auf diese Weise die Stromquelle so geregelt werden, dass sich ein konstanter Spannungsabfall am Zweipol einstellt. Die Stromquelle wirkt in diesem Frequenzbereich wie ein Konstantspannungs-Zweipol mit vorgegebenem Spannungsabfall. Erst für Wechselstrom höherer Frequenz, z.B. 1 kHz und darüber, welcher für die Impedanzmessung beispielsweise verwendet wird, wirkt der Zweipol als Konstantstrom-Zweipol und entkoppelt mit seinem hohen differenziellen Widerstand den elektrochemischen Energiespeicher von der Last. Auch die Messung von Nichtlinearitäten der Strom/Spannungs-Kennlinie des elektrochemischen Energiespeichers (THDA, Total Harmonic Distortion Analysis) ist auf diese Weise besonders vorteilhaft möglich, weil die harmonischen Frequenzen in Spannungs- und Strommessung einen geringen Pegel haben und die gute Entkopplung von den Störungen bzw. der Impedanz der Last eine präzise Auswertung erleichtert.

Ferner hat die Wechselspannung der Wechselspannungsquelle eine über der Grenzfrequenz des Spannungsreglers liegende Frequenz. Dadurch wird bei der Impedanzmessung eine effektive Entkopplung des elektrochemischen Energiespeichers von der Last bewirkt.

Günstig ist, wenn der Spannungsregler ferner einen ausgangsseitigen Tiefpass umfasst. Auf diese Weise kann die Grenzfrequenz des Spannungsreglers mithilfe des Tiefpasses eingestellt werden, sodass der Spannungsregler höhere Frequenzen nicht beeinflusst.

Ebenso ist günstig, wenn die Wechselspannungsquelle ferner einen ausgangsseitigen Hochpass umfasst. So wird ein Einfluss der Wechselspannungsquelle auf den Spannungsregler verhindert.

Um möglichen Messfehlern beim Einspeisen des den Laststrom überlagernden Wechselstroms infolge eines zu geringen Spannungsabfalls an der Stromquelle vorzubeugen, umfasst der Spannungsregler ferner bevorzugt einen Komparator, welcher dafür ausgebildet ist, jeweils zu detektieren, wenn der gemessene Spannungsabfall einen vorgegebenen Schwellwert unterschreitet, und bei Detektion ein Signal auszugeben. Dieses Signal kann in weiterer Folge bei der Bestimmung der Impedanz des elektrochemischen Energiespeichers berücksichtigt werden, z.B. indem für Zeitabschnitte, in welchen das Signal ausgegeben wird, d.h. in welchen der gemessene Spannungsabfall den vorgegebenen Schwellwert unterschreitet, die Ergebnisse der Spannungs- und Strommessung unberücksichtigt bleiben. Besonders günstig ist dabei ferner, wenn der Spannungsregler dafür ausgebildet ist, den genannten Sollwert bei Detektion zu erhöhen. So kann dem Unterschreiten des Schwellwerts direkt abgeholfen werden.

In einer vorteilhaften Variante umfasst die Vorrichtung einen dem Zweipol oder der Stromquelle parallelgeschalteten Spannungsbegrenzer. Die Stromquelle wird auf diese Weise vor Überspannung wirksam geschützt. Ferner ist es günstig, wenn die Vorrichtung einen dem Zweipol oder der Stromquelle parallelgeschalteten Leistungsschalter umfasst. Der Leistungsschalter entlastet den Zweipol bzw. die Stromquelle während Zeitabschnitten, in denen keine Impedanzmessung erforderlich ist, wodurch thermische Verluste reduziert werden und sich die Lebensdauer von Zweipol bzw. Stromquelle erhöht.

Vorteilhaft ist, wenn die Vorrichtung einen Koppelkondensator zum Anschalten des Spannungsmessgeräts an den elektrochemischen Energiespeicher umfasst. Gleichspannungsanteile können dadurch ausgekoppelt werden.

Um auch bei geringer Leistungsaufnahme der Last die Impedanz des elektrochemischen Energiespeichers messen zu können, hat die Vorrichtung bevorzugt einen der Last parallelschaltbaren Kondensator. Infolge der dadurch reduzierten lastseitigen Impedanz verursachen Laststrom und überlagerter Wechselstrom einen geringen Spannungsabfall an der Last. Damit kann auch ein geringerer Sollwert für den Spannungsabfall an der Stromquelle vorgegeben und in der Folge deren Verlustleistung insgesamt reduziert werden. Ferner wird auf diese Weise vermieden, dass es beim Einspeisen des den Laststrom überlagernden Wechselstroms zu einer Stromrichtungsumkehr kommt.

In einer vorteilhaften Ausführungsvariante der Vorrichtung ist die Stromquelle bidirektional. Dies ermöglicht das Messen der Impedanz des elektrochemischen Energiespeichers nicht nur im Falle des Speisens der Last mit einem Laststrom, sondern auch beim Laden des elektrochemischen Energiespeichers, wenn seine Bauart es zulässt.

Die Erfindung wird nachstehend anhand von in den beigeschlossenen Zeichnungen dargestellten Ausführungsbeispielen näher erläutert. In den Zeichnungen zeigt:
Fig. 1 eine erfindungsgemäße Vorrichtung zum Messen der Impedanz eines elektrochemischen Energiespeichers mit angeschlossener Last in einem schematischen Blockschaltbild; und
Fig. 2 einen Zweipol der Vorrichtung von Fig. 1 mit gesteuerter Stromquelle in einem schematischen Blockschaltbild.

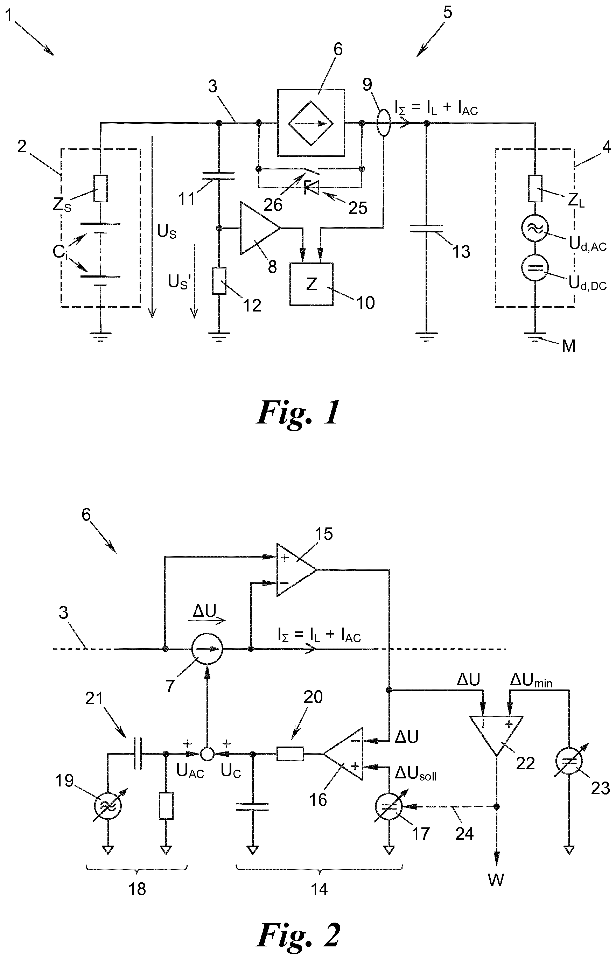

Fig. 1 zeigt an der linken Seite einer elektrischen Schaltung 1 einen elektrochemischen Energiespeicher 2 in Form eines Ersatzschaltbildes mit einer Impedanz Z_{S} und einer oder mehreren Einzelzellen Cᵢ. Der elektrochemische Energiespeicher 2 ist z.B. ein galvanisches Element, d.h. eine Batterie oder ein Ackumulator, ein Redox-Flussspeicher oder eine Brennstoffzelle, welche hier alle als unter den Begriff "elektrochemischer Energiespeicher" fallend betrachtet werden.

Über eine Leitung 3 speist der elektrochemische Energiespeicher 2 eine Last 4 mit einem Laststrom I_{L}. Der Stromkreis der Schaltung 1 ist in der Darstellung der Fig. 1 über Masse M geschlossen.

Die Last 4 kann je nach Art der Schaltung 1, d.h. je nach Anwendung, verschiedener Art sein. Beispielsweise kann es sich bei der Schaltung 1 um den elektrischen Teil eines Fahrzeugantriebs handeln, wobei die Last 4 ein elektronischer Umrichter und ein von diesem gespeister Fahrmotor ist. Es versteht sich, dass die Schaltung 1 in anderen Anwendungen mit jeweils anderer Last 4 vergleichbar aufgebaut sein kann.

Die Last 4 hat eine Impedanz Z_{L} und im dargestellten Fall Störspannungen mit Wechselanteil U_{d,Ac} bzw. Gleichanteil U_{d,DC}, welche gerade im Fall eines umrichtergespeisten Fahrmotors zusammen mit der niedrigen Impedanz Z_{L} von zwischen den Versorgungsanschlüssen des Umrichters geschalteten Elektrolytkondensatoren auf eine Messung der Impedanz Z_{S} des elektrochemischen Energiespeichers 2 erhebliche Auswirkungen haben können.

Zum Messen der Impedanz Z_{S} des elektrochemischen Energiespeichers 2 ist eine Vorrichtung 5 vorgesehen. Die Vorrichtung 5 umfasst die genannte Leitung 3 und einen Zweipol 6, welcher in die Leitung 3, d.h. in Serie zwischen den elektrochemischen Energiespeicher 2 und die Last 4, eingeschaltet ist. Der Zweipol 6 speist als Stromspeiseeinrichtung einen den Laststrom I_{L} überlagernden Wechselstrom I_{AC} in die Leitung 3 ein, wozu der Zweipol 6 eine gesteuerte Stromquelle 7 (Fig. 2) hat. Die Steuerung der Stromquelle 7 führt so durch Überlagerung des Laststroms I_{L} mit dem für die Impedanzmessung benötigten Wechselstrom I_{AC} zu einem gleichsam modulierten Gesamtstrom I_{Σ} in der Leitung 3, wie weiter unten ausführlicher erläutert wird.

Die Vorrichtung 5 umfasst ferner ein Spannungsmessgerät 8, welches dem elektrochemischen Energiespeicher 2 parallelgeschaltet ist. Das Spannungsmessgerät 8 misst die Spannung U_{S} des elektrochemischen Energiespeichers 2 bzw. einen relevanten Anteil dieser Spannung U_{S} wie weiter unten näher erläutert. Außerdem umfasst die Vorrichtung 5 ein Strommessgerät 9, welches in die Leitung 3 eingeschaltet ist, u.zw. an einer Seite oder im Inneren des Zweipols 6 (im Beispiel der Fig. 1 an der Lastseite). Das Strommessgerät 9 misst den aus dem Laststrom I_{L} und dem diesen überlagernden Wechselstrom I_{AC} zusammengesetzten Gesamtstrom I_{Σ} in der Leitung 3. Die Vorrichtung 5 umfasst überdies eine Einrichtung 10 zur Bestimmung der Impedanz Z_{S} aus der gemessenen Spannung U_{S} des elektrochemischen Energiespeichers 2 und dem gemessenen Strom I_{Σ}.

Das Spannungsmessgerät 8 ist im Beispiel der Fig. 1 über einen optionalen Koppelkondensator 11 dem elektrochemischen Energiespeicher 2 parallelgeschaltet und misst in diesem Fall eine Spannung U_{S}' an einem Widerstand 12 als für die Bestimmung der Impedanz Z_{S} relevanten Bestandteil der Spannung U_{S} des elektrochemischen Energiespeichers 2 gegenüber Masse M. Das Strommessgerät 9 misst den Strom I_{Σ} in der Leitung 3 auf bekannte Weise, z.B. mithilfe eines Shunt-Widerstands (nicht dargestellt). Auch die Impedanz Z_{S} wird in der Einrichtung 10 in dem Fachmann bekannter Weise bestimmt, u.zw. aus Spannungs- und Strommessung, bei welchen die Phasenlagen der jeweiligen Wechselanteile berücksichtigt werden.

Es versteht sich, dass anstelle oder zusätzlich zu der Impedanz Z_{S} des elektrochemischen Energiespeichers 2 die Impedanz Z_{L} der Last 4 bestimmt werden könnte, wenn dieser lastseitig des Zweipols 6 an die Leitung 3 ein Spannungsmessgerät 8 parallelgeschaltet würde.

Um einen gewünschten Arbeitspunkt des elektrochemischen Energiespeichers 2 einstellen bzw. allgemein die Impedanz Z_{L} der Last 4 zu reduzieren, kann der Last 4 optional ein Kondensator 13 parallelgeschaltet werden. Durch die Serienschaltung des elektrochemischen Energiespeichers 5 mit der gesteuerten Stromquelle 7 des Zweipols 6 und der Last 4 ist - im Gegensatz zu herkömmlichen Messverfahren - eine geringe lastseitige Impedanz durchaus erwünscht.

Gemäß dem Beispiel der Fig. 2 ist zur Steuerung der Stromquelle 7 ein Spannungsregler 14 vorgesehen. Der Spannungsregler 14 hat eine Messeinheit 15 zum Messen des Spannungsabfalls ΔU an der Stromquelle 7 und einen Verstärker 16 zum Bilden eines Steuersignals U_{C} aus einer Differenz des gemessenen Spannungsabfalls ΔU und eines vorgegebenen Sollwerts ΔUₛₒₗₗ. Der Sollwert ΔUₛₒₗₗ ist optional einstellbar, z.B. als steuerbare Gleichspannungsquelle 17 wie in Fig. 2 gezeigt. Ferner ist zur Steuerung der Stromquelle 7 eine - optional ebenfalls steuerbare - Wechselspannungsquelle 18, mit z.B. einem Signalgenerator 19, zum Einkoppeln einer Wechselspannung U_{AC} in das genannte Steuersignal U_{C} vorgesehen. Alternativ könnte die Stromquelle 7 stromgesteuert sein.

Um zu verhindern, dass der Spannungsregler 14 der Einspeisung des Wechselstroms I_{AC} gegensteuert, hat die Wechselspannung U_{AC} der Wechselspannungsquelle 18 in diesem Beispiel eine über der Grenzfrequenz des Spannungsreglers 14 liegende Frequenz. Die Grenzfrequenz des Spannungsreglers 14 könnte bei einigen 10 Hz bis wenigen 100 Hz, z.B. bei etwa 100 Hz, und die Frequenz der Wechselspannung U_{AC} könnte dabei z.B. nicht unter 1 kHz liegen. Häufig wird die Impedanz Z_{S} des elektrochemischen Energiespeichers 2 bei mehreren verschiedenen Frequenzen der Wechselspannung U_{AC} der Wechselspannungsquelle 18 bzw. des den Laststrom I_{L} überlagernden Wechselstrom I_{AC} der Stromquelle 7 bestimmt. Zum gezielten Festlegen der Grenzfrequenz umfasst der Spannungsregler 14 im Beispiel der Fig. 2 einen optionalen ausgangsseitigen Tiefpass 20. Ferner kann, wenn gewünscht, die Wechselspannungsquelle 18 einen ausgangsseitigen Hochpass 21 umfassen.

Der Spannungsabfall ΔU an der Stromquelle 7 wird einerseits dadurch verursacht, dass der eingeprägte Wechselstrom I_{AC} an den Impedanzen Z_{S}, Z_{L} des elektrochemischen Energiespeichers 2 und der Last 4 jeweils einen Spannungsabfall bewirkt, andererseits wirken die Störspannungen U_{d,AC}, U_{d,DC} der Last 4 ebenfalls auf die Stromquelle 7, u.zw. insbesondere im Bereich höherer Frequenzen. Dabei sollte der Spannungsabfall ΔU an der Stromquelle 7 für deren korrektes Funktionieren einerseits nicht zu klein werden, wie in weiterer Folge näher erläutert wird; ein zu hoher Spannungsabfall ΔU führt andererseits insbesondere bei hohen Laststrom I_{L} zu einer unerwünscht hohen Verlustleistung an der Stromquelle 7.

Unterschreitet der Spannungsabfall ΔU an der Stromquelle 7 einen Schwellwert ΔUₘᵢₙ, kann die Stromquelle 7 an der Last 4 auftretende Störspannungen U_{d,AC}, U_{d,DC} nicht mehr vollständig kompensieren. Greifen in der Folge die lastseitigen Störungen auf die Seite des elektrochemischen Energiespeichers 2 durch, werden die Ergebnisse von Spannungs- und Strommessung verfälscht; die Impedanz Z_{S} des elektrochemischen Energiespeichers 2 kann in diesem Fall nicht mehr zuverlässig bestimmt werden. Zur möglichen Abhilfe umfasst der Spannungsregler 14 im Beispiel der Fig. 2 einen optionalen Komparator 22. Der Komparator 22 detektiert jeweils, wenn der gemessene Spannungsabfall ΔU den Schwellwert ΔUₘᵢₙ unterschreitet, und gibt bei Detektion, d.h. für die Dauer des Unterschreitens, ein Signal W aus. Der Schwellwert ΔUₘᵢₙ ist beispielsweise unveränderlich oder durch eine weitere steuerbare Gleichspannungsquelle 23 od. dgl. vorgebbar.

Das Signal W kann dazu genutzt werden, potentiell fehlerhafte Spannungs- und Strommessergebnisse bei der Bestimmung der Impedanz Z_{S} des elektrochemischen Energiespeichers 2 - z.B. direkt in der Einrichtung 10 - zu unterdrücken und die Bestimmung der Impedanz Z_{S} während der Dauer der Detektion auszusetzen. Alternativ oder ergänzend dazu kann das Signal W - wie durch die strichlierte Linie 24 in Fig. 2 versinnbildlicht - den genannten Sollwert ΔUₛₒₗₗ beeinflussen, indem beispielsweise durch Ansteuerung der Gleichspannungsquelle 17 dem Spannungsregler 14 ein erhöhter Sollwert ΔUₛₒₗₗ vorgegeben wird.

Analog dazu könnte auch ein Überschreiten einer Obergrenze für den Spannungsabfall ΔU detektiert werden, sodass zum Schutz der Stromquelle 7 entsprechende Maßnahmen eingeleitet werden können, z.B. die Ausgabe eines weiteren Signals zur Warnung oder die Vorgabe eines reduzierten Sollwerts ΔUₛₒₗₗ.

Zurückkommend auf das Beispiel in Fig. 1 kann die Vorrichtung 5 zum Schutz der Stromquelle 7 ferner optional einen Spannungsbegrenzer 25 haben, welcher dem Zweipol 6 oder direkt der Stromquelle 7 parallelgeschaltet ist und so ein Überschreiten der Obergrenze für den Spannungsabfall ΔU wirksam verhindert. Der Spannungsbegrenzer 25 kann beispielsweise eine Zenerdiode od.dgl. sein. Ferner kann optional dem Zweipol 6 oder der Stromquelle 7 ein Leistungsschalter 26 parallelgeschaltet sein. Der Leistungsschalter 26 wird dabei in jenen Zeitabschnitten geschlossen, in welchen eine Impedanzmessung nicht erforderlich ist, sodass der Laststrom I_{L} über den Leistungsschalter 26 und nicht den Zweipol 6 bzw. die Stromquelle 7 geführt wird.

Die Erfindung ist nicht auf die dargestellten Ausführungsformen beschränkt, sondern umfasst alle Varianten, Kombinationen und Modifikationen, die in den Rahmen der angeschlossenen Ansprüche fallen. Insbesondere kann die Vorrichtung 5 mit analogen und/oder - nach analog-digital-Wandlung - zumindest teilweise mit digitalen Bausteinen und dabei einzelne Funktionen optional in Form von Softwaremodulen realisiert sein.

## Patentansprüche

1. Vorrichtung zum Messen der Impedanz (Z_{S}) eines elektrochemischen Energiespeichers (2), welcher eine angeschlossene Last (4) mit einem Laststrom (I_{L}) über eine Leitung (3) speist, umfassend:
die genannte Leitung (3),
eine Stromspeiseeinrichtung zum Einspeisen eines den Laststrom (I_{L}) überlagernden Wechselstroms (I_{AC}),
ein dem elektrochemischen Energiespeicher (2) parallelschaltbares Spannungsmessgerät (8) zur Spannungsmessung,
ein in die Leitung (3) eingeschaltetes Strommessgerät (9) zur Strommessung, und
eine Einrichtung (10) zur Bestimmung der Impedanz (Z_{S}) aus Spannungs- und Strommessung,
wobei die Stromspeiseeinrichtung ein in die Leitung (3) eingeschalteter Zweipol (6) mit gesteuerter Stromquelle (7) ist,
**dadurch gekennzeichnet,**
**dass** zur Steuerung der Stromquelle (7) ein Spannungsregler (14), welcher eine Messeinheit (15) zum Messen des Spannungsabfalls (ΔU) an der Stromquelle (7) und einen Verstärker (16) zum Bilden eines Steuersignals (U_{C}) aus einer Differenz des gemessenen Spannungsabfalls (ΔU) und eines vorgegebenen Sollwerts (ΔUₛₒₗₗ) umfasst, und eine Wechselspannungsquelle (18) zum Einkoppeln einer Wechselspannung (U_{AC}) in das genannte Steuersignal (U_{C}) vorgesehen sind,
wobei die Wechselspannung (U_{AC}) der Wechselspannungsquelle (18) eine über der Grenzfrequenz des Spannungsreglers (14) liegende Frequenz hat.

2. Vorrichtung nach Anspruch 1, **dadurch gekennzeichnet, dass** der Spannungsregler (14) ferner einen ausgangsseitigen Tiefpass (20) umfasst.

3. Vorrichtung nach Anspruch 1 oder 2, **dadurch gekennzeichnet, dass** die Wechselspannungsquelle (18) ferner einen ausgangsseitigen Hochpass (21) umfasst.

4. Vorrichtung nach einem der Ansprüche 1 bis 3, **dadurch gekennzeichnet, dass** der Spannungsregler (14) ferner einen Komparator (22) umfasst, welcher dafür ausgebildet ist, jeweils zu detektieren, wenn der gemessene Spannungsabfall (ΔU) einen vorgegebenen Schwellwert (ΔUₘᵢₙ) unterschreitet, und bei Detektion ein Signal (W) auszugeben.

5. Vorrichtung nach Anspruch 4, **dadurch gekennzeichnet, dass** der Spannungsregler (14) dafür ausgebildet ist, den genannten Sollwert (ΔUₛₒₗₗ) bei Detektion zu erhöhen.

6. Vorrichtung nach einem der Ansprüche 1 bis 5, **gekennzeichnet durch** einen dem Zweipol (6) oder der Stromquelle (7) parallelgeschalteten Spannungsbegrenzer (25).

7. Vorrichtung nach einem der Ansprüche 1 bis 6, **gekennzeichnet durch** einen dem Zweipol (6) oder der Stromquelle (7) parallelgeschalteten Leistungsschalter (26).

8. Vorrichtung nach einem der Ansprüche 1 bis 7, **gekennzeichnet durch** einen Koppelkondensator (11) zum Anschalten des Spannungsmessgeräts (8) an den elektrochemischen Energiespeicher (2) .

9. Vorrichtung nach einem der Ansprüche 1 bis 8, **gekennzeichnet durch** einen der Last (4) parallelschaltbaren Kondensator (13).

10. Vorrichtung nach einem der Ansprüche 1 bis 9, **dadurch gekennzeichnet, dass** die Stromquelle (7) bidirektional ist.

## Claims

1. Apparatus for measuring the impedance (Z_{S}) of an electrochemical energy storage (2) feeding a connected load (4) with a load current (I_{L}) via a line (3), comprising:
said line (3),
a current feeding device for feeding an alternating current (I_{AC}) superimposing the load current (I_{L}),
a voltmeter (8) connectable in parallel with the electrochemical energy storage (2), for voltage measurement,
an ammeter (9) inserted in the line (3), for current measurement, and
a device (10) for determining the impedance (Z_{S}) from the voltage and current measurements,
wherein the current feeding device is a two terminal element (6) which is inserted in the line (3) and has a controlled current source (7),
**characterized in that**
for controlling the current source (7), a voltage regulator (14), which comprises a measuring unit (15) for measuring the voltage drop (ΔU) at the current source (7) and an amplifier (16) for generating a control signal (U_{C}) from a difference of the measured voltage drop (ΔU) and a predetermined set point value (ΔUₛₒₗₗ), and an alternating voltage source (18) for coupling an alternating voltage (U_{AC}) into said control signal (U_{C}) are provided,
wherein the alternating voltage (U_{AC}) of the alternating voltage source (18) has a frequency lying above the cut-off frequency of the voltage regulator (14).

2. Apparatus according to claim 1, **characterized in that** the voltage regulator (14), on the output, side further comprises a low pass filter (20).

3. Apparatus according to claim 1 or 2, **characterized in that** the alternating voltage source (18), on the output side, further comprises a high pass filter (21).

4. Apparatus to any one of claims 1 to 3, **characterized in that** the voltage regulator (14) further comprises a comparator (22) configured to detect each time the measured voltage drop (ΔU) falls below a preset threshold (ΔUₘᵢₙ) and to output a signal (W) upon detection.

5. Apparatus according to claim 4, **characterized in that** the voltage regulator (14) is configured to increase said set point value (ΔUₛₒₗₗ) upon detection.

6. Apparatus according to any one of claims 1 to 5, **characterized by** a voltage limiter (25) connected in parallel with the two terminal element (6) or with the current source (7) .

7. Apparatus according to any one of claims 1 to 6, **characterized by** a power switch (26) connected in parallel with the two terminal element (6) or with the current source (7).

8. Apparatus according to any one of claims 1 to 7, **characterized by** a coupling capacitor (11) for linking the voltmeter (8) with the electrochemical energy storage (2).

9. Apparatus according to any one of claims 1 to 8, **characterized by** a capacitor (13) connectable in parallel with the load (4).

10. Apparatus according to any one of the claims 1 to 9, **characterized in that** the current source (7) is bidirectional.

## Revendications

1. Appareil de mesure de l'impédance (Z_{S}) d'un accumulateur d'énergie (2) électrochimique, lequel alimente une charge (4) connectée avec un courant sous charge (I_{L}) par le biais d'une ligne (3), comprenant :
ladite ligne (3),
un dispositif d'alimentation en courant pour l'alimentation d'un courant alternatif (I_{AC}) se superposant au courant sous charge (I_{L}),
un voltmètre (8) pouvant être branché en parallèle sur l'accumulateur d'énergie (2) électrochimique, pour la mesure de la tension,
un ampèremètre (9) intercalé dans la ligne (3), pour la mesure de l'intensité de courant, et
un dispositif (10) de détermination de l'impédance (Z_{S}) à partir des mesures de tension et d'intensité de courant,
où le dispositif d'alimentation en courant est un dipôle (6) avec une source de courant (7) commandée intercalé dans la ligne (3),
**caractérisé en ce**
**qu'**un régulateur de tension (14), lequel comprend une unité de mesure (15) permettant la mesure de la chute de tension (ΔU) au niveau de la source de courant (7) et un amplificateur (16) permettant la production d'un signal de commande (U_{C}) à partir d'une différence de la chute de tension (ΔU) mesurée et d'une valeur de consigne (ΔUₛₒₗₗ) prédéfinie, et une source de tension alternative (18) permettant le couplage d'une tension alternative (U_{AC}) dans ledit signal de commande (U_{C}) sont prévus pour la commande de la source de courant (7),
où la tension alternative (U_{AC}) de la source de tension alternative (18) a une fréquence se situant au-dessus de la fréquence limite du régulateur de tension (14).

2. Appareil selon la revendication 1, **caractérisé en ce que** le régulateur de tension (14) comprend en outre un passe-bas (20) du côté de la sortie.

3. Appareil selon la revendication 1 ou la revendication 2, **caractérisé en ce que** la source de tension alternative (18) comprend en outre un passe-haut (21) du côté de la sortie.

4. Appareil selon l'une des revendications 1 à 3, **caractérisé en ce que** le régulateur de tension (14) comprend en outre un comparateur (22), lequel est conçu pour détecter, respectivement, si la chute de tension (ΔU) mesurée dépasse vers le bas une valeur de seuil (ΔUₘᵢₙ) prédéterminée, et pour émettre un signal (W) en cas de détection.

5. Appareil selon la revendication 4, **caractérisé en ce que** le régulateur de tension (14) est conçu pour augmenter ladite valeur de consigne (ΔUₛₒₗₗ) en cas de détection.

6. Appareil selon l'une des revendications 1 à 5, **caractérisé par** un limiteur de tension (25) branché en parallèle sur le dipôle (6) ou sur la source de courant (7).

7. Appareil selon l'une des revendications 1 à 6, **caractérisé par** un disjoncteur de puissance (26) branché en parallèle sur le dipôle (6) ou sur la source de courant (7).

8. Appareil selon l'une des revendications 1 à 7, **caractérisé par** un condensateur de couplage (11) permettant de coupler le voltmètre (8) à l'accumulateur d'énergie (2) électrochimique.

9. Appareil selon l'une des revendications 1 à 8, **caractérisé par** un condensateur (13) pouvant être branché en parallèle sur la charge (4).

10. Appareil selon l'une des revendications 1 à 9, **caractérisé en ce que** la source de courant (7) est bidirectionnelle.
